# EUROPEAN PATENT APPLICATION

(11) **EP 4 676 195 A1**
(43) Date of publication of application: **07.01.2026**
(21) Application number: 25181705.2
(22) Date of filing: 10.06.2025
(51) Int. Cl.: H10H 20/819, H10H 20/831, H10H 29/32, H10H 29/34, H10H 29/80

(54) **MATRIX LED DISPLAY**

(30) Priority: 02.07.2024 JP 2024106770
(71) Applicant: Alps Alpine Co., Ltd., Ota-ku, Tokyo 145-8501 (JP)
(72) Inventor: Kishida, Katsuhiko, Iwaki-city Fukushima (JP)
(74) Representative: Schmitt-Nilson Schraud Waibel Wohlfrom Patentanwälte Partnerschaft mbB

(57) **Abstract**

A matrix LED display includes a plurality of LED chips disposed in a matrix on an interconnect substrate provided with a plurality of common interconnects extending in a first direction and a plurality of segment interconnects extending in a second direction orthogonal to the first direction. Each of the LED chips is configured by a pn junction in which p-type and n-type semiconductor layers are joined in a vertical structure, and includes a p-type electrode and an n-type electrode. Each of the common interconnects is disposed to pass through the LED chips disposed in the same row, and is connected to an n-type electrode of each of the LED chips. Each of the segment interconnects is disposed to pass through the LED chips disposed in the same column, and is connected to a p-type electrode of each of the LED chips.

## Description

The present disclosure relates to a matrix LED display in which extremely small LEDs are disposed in a matrix at respective pixel positions.

The matrix LED display is a flat panel display in which minute LEDs are disposed in a matrix at respective pixel positions, and is superior in contrast, response speed, and energy efficiency to existing backlight type liquid crystal displays. The plurality of LEDs disposed in a matrix are connected to a drive circuit or the like by interconnects on a substrate on which the LEDs are mounted.

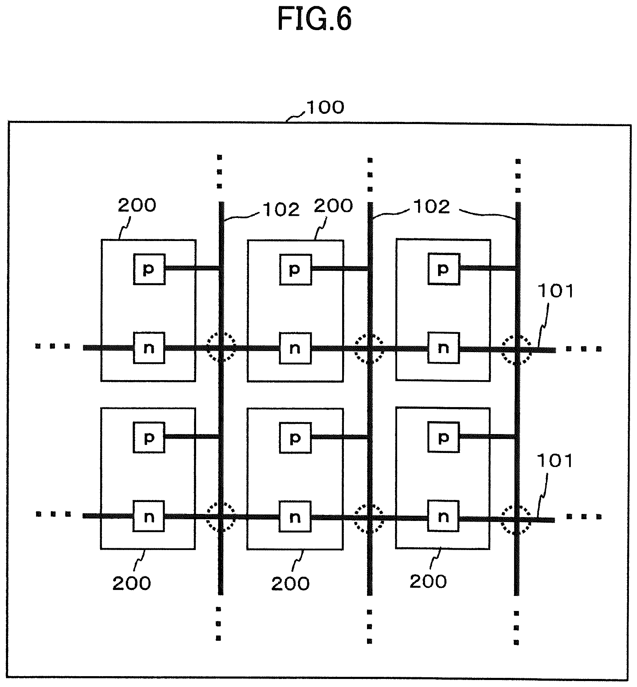

As illustrated in FIG. 6, the interconnects on a substrate 100 include common interconnects 101 and segment interconnects 102 that are disposed in directions orthogonal to each other. The common interconnect 101 is an interconnect common to a plurality of LED chips 200 disposed in the same row, and a plurality of n-type electrodes (cathode electrodes) of the LED chips 200, for example, are connected to this common interconnect 101. The segment interconnect 102 is an interconnect for each segment in a plurality of LED chips 200 disposed in the same column, and a plurality of p-type electrodes (anode electrodes) of the LED chips 200, for example, are connected to this segment interconnect 102. FIG. 6 schematically illustrates an interconnect structure on the interconnect substrate 100 in a state where the LED chips 200 are seen through to the electrodes from above the interconnect substrate 100.

As indicated by the dotted circles in FIG. 6, since the common interconnects 101 and the segment interconnects 102 intersect on the substrate 100, the substrate 100 requires two conductive layers, and it is necessary to provide through-holes and connect the interconnects between the two layers through via conductors. For example, JP 2021-182613 A and JP 2021-504752 A disclose such an interconnect arrangement having a two-layer structure. However, the need of through-holes in two conductive layers makes it difficult to implement some type of displays with a micro LED technology. For example, in a transmissive display configured to allow the back to be seen through, a flexible display having flexibility, or the like, it is necessary to use a transparent substrate, a film substrate, an elastic substrate, or the like, but it is difficult to realize a substrate having high transmittance or flexibility with a two layer structure.

In a sub-pixel including an X-direction terminal connected to an interconnect extending in the X direction and a Y-direction terminal connected to an interconnect extending in the Y direction, a microLED display is known in which the Y-direction terminal is configured by a first region and a second region provided at an interval from the first region (the Y-direction terminal is divided in a direction intersecting the Y direction), the interconnect extending in the X direction is continuously provided in the X direction by passing between the first region and the second region in the Y-direction terminal, and the first region and the second region are bridge-connected by an LED electrode (see JP 2022-61868 A for example).

The present disclosure relates to a matrix LED display according to the appended claims. Embodiments are disclosed in the dependent claims.

A matrix LED display according to an aspect of the present disclosure includes a plurality of LED chips disposed in a matrix on an interconnect substrate provided with a plurality of common interconnects extending in a first direction and a plurality of segment interconnects extending in a second direction orthogonal to the first direction. Each of the LED chips is configured by a pn junction in which a p-type semiconductor layer and an n-type semiconductor layer are joined in a vertical structure, and includes a p-type electrode and an n-type electrode provided in an insulated state. Each of the common interconnects is disposed at a position where the common interconnect passes through a plurality of LED chips disposed in a same row extending in the first direction, and is connected to one of the p-type electrode or an n-type electrode of each of the plurality of LED chips disposed in the same row. Each of the segment interconnects is disposed at a position where the segment interconnect passes through the plurality of LED chips disposed in a same column extending in the second direction, and is connected to the other electrode of each of the plurality of LED chips disposed in the same column.
FIG. 1 is a diagram illustrating an example of an interconnect arrangement of a matrix LED display according to an embodiment;
FIG. 2 is a diagram schematically illustrating an example of a side sectional structure of an LED chip;
FIG. 3 is a diagram illustrating another example of an interconnect arrangement of a matrix LED display according to an embodiment;
FIG. 4 is a diagram schematically illustrating another example of a side sectional structure of an LED chip;
FIG. 5 is a diagram schematically illustrating yet another example of a side sectional structure of an LED chip; and
FIG. 6 is a diagram illustrating an example of an interconnect arrangement of a conventional matrix LED display.

According to aspects of the present disclosure, intersection of the common interconnect and the segment interconnect on the interconnect substrate is eliminated because of three-dimensional intersecting of a conduction path in the first direction, which is configured by connecting one of the p-type electrode or the n-type electrode to the common interconnect, and a conduction path in the second direction, which is configured by connecting the other electrode to the segment interconnect, in the LED chip through the vertical structure of the pn junction. This makes it possible to configure a matrix LED display with a single-layer interconnect substrate without using a configuration in which the divided Y-direction terminals are bridge-connected by the LED electrodes as in JP 2022-61868 A.

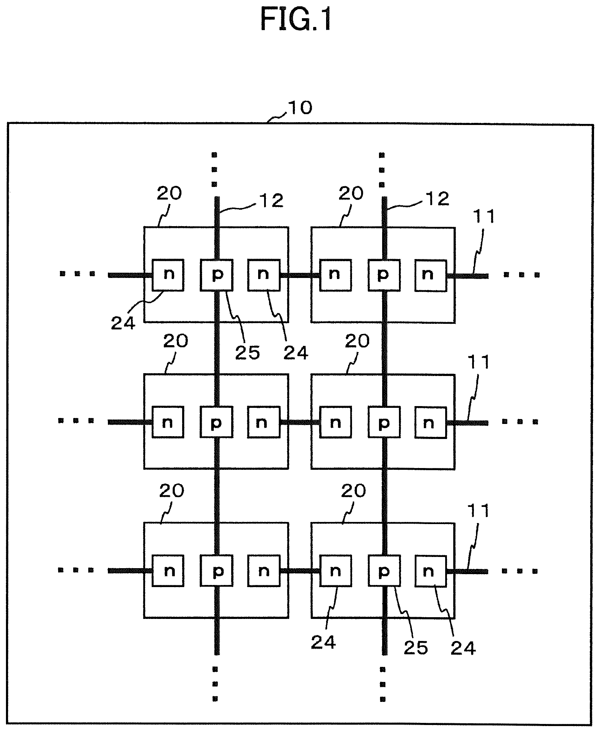

Embodiments of the present disclosure will be described below with reference to the drawings. FIG. 1 is a diagram illustrating an example of an interconnect arrangement of a matrix LED display according to an embodiment. FIG. 1 schematically illustrates an interconnect structure on an interconnect substrate 10 of a matrix LED display in a state where LED chips 20 are seen through to electrodes 24 and 25 from above the interconnect substrate 10.

As illustrated in FIG. 1, the matrix LED display of the present embodiment is configured by arranging a plurality of LED chips 20 in a matrix on interconnect substrate 10 provided with a plurality of common interconnects 11 extending in a first direction (row direction) and a plurality of segment interconnects 12 extending in a second direction (column direction) orthogonal to the first direction.

In the present embodiment, the common interconnect 11 is disposed at a position where the common interconnect 11 passes through the plurality of LED chips 20 disposed in an array in the first direction, and the segment interconnect 12 is disposed at a position where the segment interconnect 12 passes through the plurality of LED chips 20 disposed in an array in the second direction. Herein, the common interconnect 11 is connected to n-type electrodes 24 (cathode electrodes) of the LED chips 20, and the segment interconnect 12 is connected to p-type electrodes 25 (anode electrodes) of the LED chips 20.

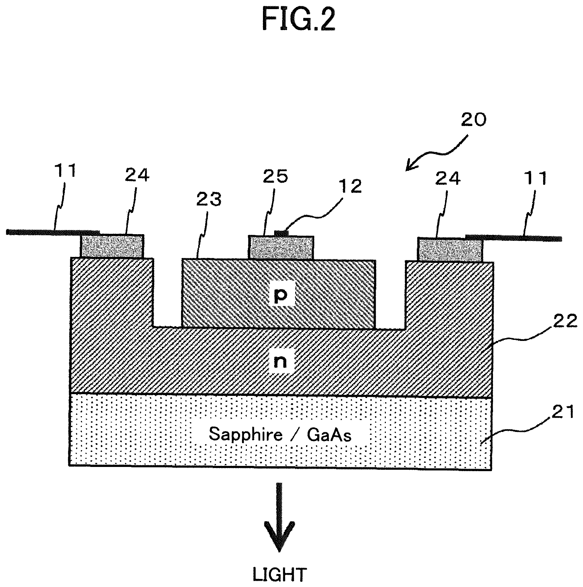

FIG. 2 is a diagram schematically illustrating an example of a side sectional structure of one of the plurality of LED chips 20. As illustrated in FIG. 2, the LED chip 20 is configured by a pn junction in which an n-type semiconductor layer 22 and a p-type semiconductor layer 23 are vertically bonded to each other on a substrate 21. The n-type semiconductor layer 22 is formed to have a substantially U-shaped cross section, and is configured in such a manner that an end surface of the n-type semiconductor layer 22 is aligned with an end surface of the p-type semiconductor layer 23.

The LED chip 20 has the n-type electrode 24 to which the common interconnect 11 is connected and the p-type electrode 25 to which the segment interconnect 12 is connected, and the n-type electrode 24 and the p-type electrode 25 are provided in an insulated state. In the present embodiment, each LED chip 20 includes two n-type electrodes 24 and one p-type electrode 25. As illustrated in FIG. 1, the two n-type electrodes 24 are disposed at positions in such a manner that the p-type electrode 25 are interposed between the two n-type electrodes 24 along the first direction in which the common interconnect 11 is disposed.

The two n-type electrodes 24 are connected to the n-type semiconductor layer 22, and the one p-type electrode 25 is connected to the p-type semiconductor layer 23. As described above, since the end face of the n-type semiconductor layer 22 and the end face of the p-type semiconductor layer 23 are flush with each other and the heights of the n-type semiconductor layer 22 and the p-type semiconductor layer 23 are aligned, the n-type electrodes 24 and the p-type electrode 25 are provided in the same layer in an insulated state.

As described above, the common interconnect 11 is disposed at a position where the common interconnect 11 passes through the plurality of LED chips 20 disposed in an array in the first direction, and is connected to two n-type electrodes 24 of each LED chip 20. Thus, a conduction path in the first direction is formed by repeating the common interconnect 11, one of the n-type electrodes 24 of the LED chip 20, the n-type semiconductor layer 22 of the LED chip 20, the other n-type electrodes 24 of the LED chip 20, the common interconnect 11 and as such in this sequence in the first direction.

The segment interconnect 12 is disposed at a position where the segment interconnect 12 passes through the plurality of LED chips 20 disposed in an array in the second direction, and is connected to one p-type electrode 25 of each LED chip 20. Thus, a conduction path in the second direction is formed by repeating the segment interconnect 12, the p-type electrode 25 of the LED chip 20, the segment interconnect 12 and as such in this sequence in the second direction.

According to the matrix LED display of the present embodiment configured as described above, the conduction path in the first direction formed by connecting the n-type electrode 24 and the common interconnect 11 and the conduction path in the second direction formed by connecting the p-type electrode 25 and the segment interconnect 12 three-dimensionally intersect with each other in the LED chip 20 by using the vertical structure of the pn junction of the LED chip 20, and thus the common interconnect 11 and the segment interconnect 12 do not intersect with each other in the interconnect substrate 10. This makes it possible to form a matrix LED display with a single layer of the interconnect substrate 10.

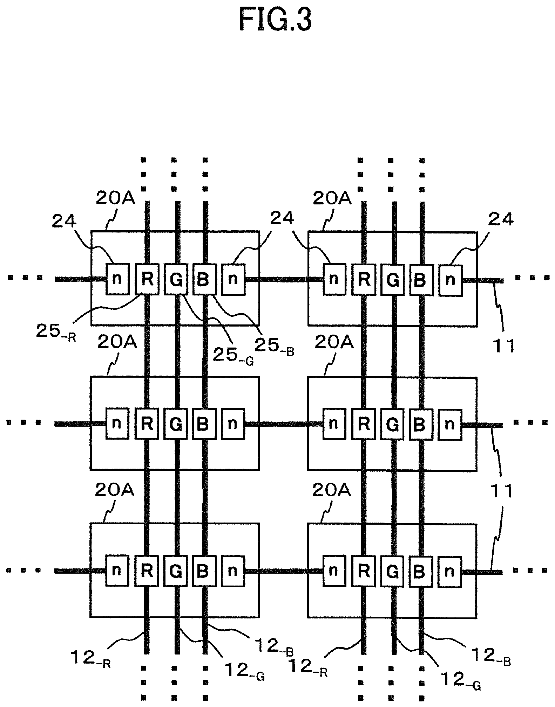

In the above embodiment, the LED chip 20 is a monochromatic light-emitting chip, and one p-type electrode 25 is provided between two n-type electrodes 24 for monochromatic light emission, but the present embodiment is not limited thereto. For example, as illustrated in FIG. 3, the present embodiment can be applied to a matrix LED display having a configuration using a multicolor emission type LED chip 20A in which a plurality of p-type electrodes 25 are provided between two n-type electrodes 24 for multicolor emission.

In the example illustrated in FIG. 3, three p-type electrodes 25-R, 25-G, and 25-B for three-color light emission of red, green, and blue are provided between two n-type electrodes 24. The segment interconnects 12 are provided for respective colors. Specifically, the segment interconnects 12-R, 12-G, and 12-B for red, green and blue are connected to the p-type electrodes 25-R, 25-G, and 25-B for red, green and blue, respectively. The connection between the common interconnect 11 and the two n-type electrodes 24 is the same as that in FIG. 1.

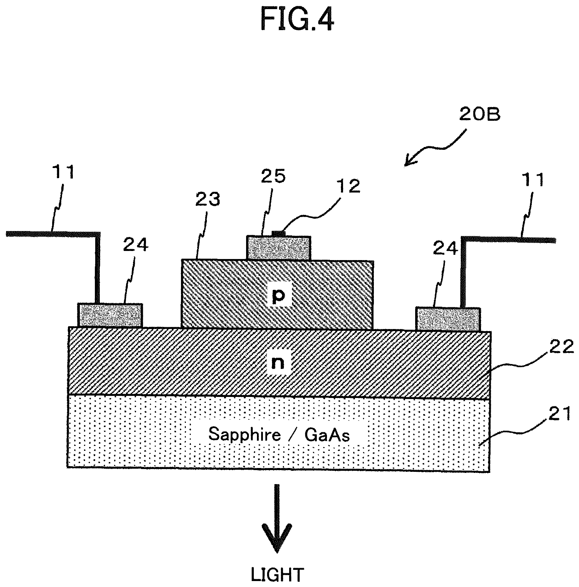

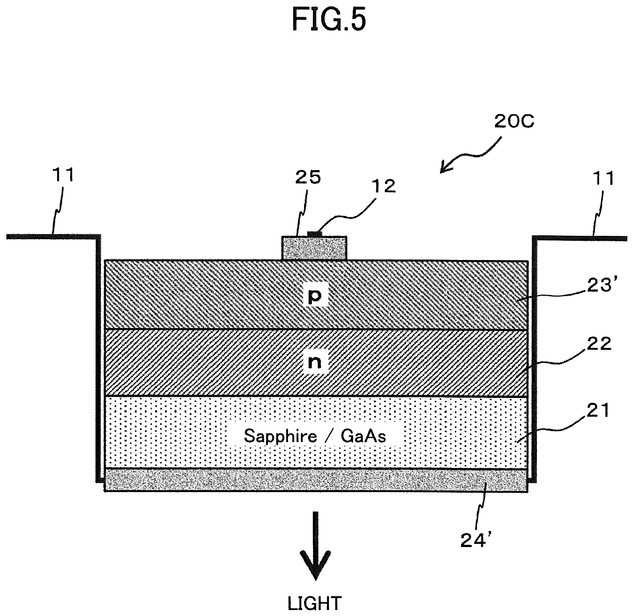

In the above embodiment, the n-type electrode 24 and the p-type electrode 25 of the LED chip 20 are provided in the same layer as illustrated in FIG. 2; however, the present embodiment is not limited to this example. For example, as in the LED chip 20B illustrated in FIG. 4 or the LED chip 20C illustrated in FIG. 5, the n-type electrodes 24 or 24' and the p-type electrode 25 may be provided in different layers in an insulated state. In this case, the common interconnect 11 of the interconnect substrate 10 and the n-type electrode 24 or 24' of the LED chip 20B or 20C are connected by wire bonding or the like. The configuration of FIG. 2 described above is more preferable than the configurations illustrated in FIGS. 4 and 5 in that wire bonding is not required.

The LED chip 20C illustrated in FIG. 5 is an example of a vertical LED chip in which the n-type electrode 24' and the p-type electrode 25 are disposed in a vertical structure. In other words, the LED chip 20C is formed by a pn junction in which the n-type semiconductor layer 22 and the p-type semiconductor layer 23' are entirely joined in a vertical structure, and the p-type electrode 25 is connected to the p-type semiconductor layer 23', and one n-type electrode 24' is provided on the back surface of the substrate 21.

In the case of the LED chip 20C illustrated in FIG. 5, a conduction path in the first direction is formed by repeating the common interconnect 11, the n-type electrode 24' of the LED chip 20C, the common interconnect 11 and as such in this sequence in the first direction. A conduction path in the second direction is formed by repeating the segment interconnect 12, the p-type electrode 25 of the LED chip 20C, the segment interconnect 12 and as such in this sequence in the second direction.

In the above-described embodiment, the p-type and the n-type may be reversed.

The above-described embodiments are merely examples for carrying out the present disclosure, and the technical scope of the present disclosure should not be interpreted in a limited manner by these embodiments. In other words, the present disclosure can be implemented in various forms without departing from the scope of the claims.

## Claims

1. A matrix LED display, comprising:
a plurality of LED chips disposed in a matrix on an interconnect substrate provided with a plurality of common interconnects extending in a first direction and a plurality of segment interconnects extending in a second direction orthogonal to the first direction, wherein
each of the LED chips is configured by a pn junction in which a p-type semiconductor layer and an n-type semiconductor layer are joined in a vertical structure, and includes a p-type electrode and an n-type electrode provided in an insulated state,
each of the common interconnects is disposed at a position where the common interconnect passes through a plurality of LED chips disposed in a same row extending in the first direction, and is connected to one of the p-type electrode or the n-type electrode of each of the plurality of LED chips disposed in the same row, and
each of the segment interconnects is disposed at a position where the segment interconnect passes through the plurality of LED chips disposed in a same column extending in the second direction, and is connected to the other electrode of each of the plurality of LED chips disposed in the same column.

2. The matrix LED display according to claim 1, wherein
one or more of the LED chips includes two n-type electrodes as the one electrode, the two n-type electrodes are connected to the n-type semiconductor layer, and the p-type electrode as the other electrode is connected to the p-type semiconductor layer, and
the two n-type electrodes are disposed at positions in such a manner that the p-type electrode is interposed between the two n-type electrodes.

3. The matrix LED display according to claim 1 or 2, wherein
one or more of the LED chips includes two p-type electrodes as the one electrode, the two p-type electrodes are connected to the p-type semiconductor layer, and the n-type electrode as the other electrode is connected to the n-type semiconductor layer,
the two p-type electrodes are disposed at positions in such a manner that the n-type electrode is interposed between the two p-type electrodes.

4. The matrix LED display according to one of claims 1 to 3, wherein
each of the plurality of LED chips is a monochromatic light-emitting chip, and the other electrode is provided for monochromatic light emission.

5. The matrix LED display according to one of claims 1 to 4, wherein
each of the plurality of LED chips is a multicolor light-emitting chip, and the other electrode is provided in plurality for multicolor light emission,
a plurality of the segment interconnects are provided corresponding to respective colors of the multicolor light emission, and
the segment interconnects for respective colors are respectively connected to the other electrodes of respective colors.

6. The matrix LED display according to one of claims 1 to 5, wherein
the n-type electrode and the p-type electrode of one or more of the LED chips are provided in a same layer in an insulated state.

7. The matrix LED display according to one of claims 1 to 5, wherein
the n-type electrode and the p-type electrode of one or more of the LED chips are provided in different layers in an insulated state.
